(19) Europäisches Patentamt
European Patent Office
Office européen des brevets

(11) Veröffentlichungsnummer: **0 249 279 B1**

(12) **EUROPÄISCHE PATENTSCHRIFT**

(45) Veröffentlichungstag der Patentschrift: **31.03.93**

(51) Int. Cl.$^5$: **H03H 17/06**

(21) Anmeldenummer: **87201035.0**

(22) Anmeldetag: **02.06.87**

# (54) Digitales Filter.

(30) Priorität: **10.06.86 DE 3619425**

(43) Veröffentlichungstag der Anmeldung:
**16.12.87 Patentblatt 87/51**

(45) Bekanntmachung des Hinweises auf die Patenterteilung:
**31.03.93 Patentblatt 93/13**

(84) Benannte Vertragsstaaten:
**DE FR GB IT**

(56) Entgegenhaltungen:

**PROCEEDINGS OF THE 7TH SYMPOSIUM ON COMPUTERARITHMETIC, Urbana, 4.-6. Juni 1985, Seiten 38-43, IEEE, New York, US; S.P. SMITH et al.: "Design of a fast inner product processor"**

**IEEE INTERNATIONAL CONFERENCE ON ACOUSTICS, SPEECH, AND SIGNAL PROCESSING, San Diego, 19.-21. März 1984, Seiten 44.7.1 - 44.7.4, IEEE, New York, US; W. ULBRICH et al.: "MOS-VLSI pipelined digital filters for video applications"**

(73) Patentinhaber: **Philips Patentverwaltung GmbH**
**Wendenstrasse 35 Postfach 10 51 49**
**W-2000 Hamburg 1(DE)**
(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**
(84) Benannte Vertragsstaaten:
**FR GB IT**

(72) Erfinder: **Heck, Berthold, Dipl.-Ing.**
**Bürgweg 36**
**W-8500 Nürnberg 30(DE)**
Erfinder: **Speidel, Joachim, Dr.-Ing.**
**Osternoherstrasse 19**
**W-8500 Nürnberg 30(DE)**

(74) Vertreter: **Peuckert, Hermann, Dipl.-Ing. et al**
**Philips Patentverwaltung GmbH Wendenstrasse 35 Postfach 10 51 49**
**W-2000 Hamburg 1 (DE)**

EP 0 249 279 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein digitales Filter, bei dem die W-stelligen Codeworte eines Eingangssignals bitparallel verarbeitet und die K Koeffizienten des Filters als P-stellige Codeworte des CSD-Codes verwendet werden.

Ein Filter mit den angegebenen Merkmalen ist z.B. in einem Artikel von W. Ulbrich et al. (Ulbrich, W., Noll, T. und Zehner, B.: MOS-VLSI Pipelined Digital Filters for Videoapplications. Proc. ICASSP 84. San Diego CA, US März 1984, s. 44.7.1 - 44.7.4.) beschrieben.

Beim Entwurf digitaler Filter gibt es mehrere Wege. Eine skizzenhafte Darstellung dieser Möglichkeiten sei am Beispiel eines nicht rekursiven Filters gegeben, dessen Eigenschaften im Zeitbereich durch die Ausgangsgleichung

$$y(n) = \sum_{k=0}^{K-1} h(k)x(n-k) \qquad (1)$$

beschrieben wird, wobei die h(k) mit k = 0, 1, 2... K-1 die K Koeffizienten des Filters bedeuten, x(n-k) die Abtastwerte des Eingangssignales darstellen, und zwar zu Zeitpunkten, die durch die ganzzahlige Variable n-k verkürzt charakterisiert sind; y(n) gibt die Ausgangsvariable des Filters zum Zeitpunkt n an.

Im Frequenzbereich wird das Filter durch seine Übertragungsfunktion

$$H(z) = \sum_{k=0}^{K-1} h(k)z^{-k} \qquad (2)$$

beschrieben.

Zu unterschiedlichen Filterstrukturen gelangt man nun, wenn man die Gleichung (1) oder (2) unterschiedlich auswertet. Eine direkte Auswertung von (1) wäre die Abspeicherung von K aufeinander folgenden Abtastwerten, die Multiplikation eines jeden Abtastwertes mit dem zugeordneten Filterkoeffizienten und die anschließende Summierung aller Produkte. Ein solcher Weg führt jedoch zu bauteileaufwendigen Filtern. Ein weiterer Weg zur Auswertung von (1) ist unter dem Terminus "verteilte Arithmetik" bekannt (vgl. hierzu z.B. Büttner, H. und Schüßler, H.-W.: On Structures for the Implementation of the Distributed Arithmetic. Nachrichtentech. Z. 29 (1976) H.6, S. 472 - 477.). Bei ihm werden die Abtastwerte im Dualcode dargestellt. In (1) erscheinen dann Produkte zwischen den Filterkoeffizienten und binären Variablen. Die Variablen werden als variable Adressen gedeutet und an die Adresseneingänge eines ROM's gelegt, dessen Ausgangsdaten in jedem Einzelfall das gewünschte Produkt darstellen. Derart strukturierte Filter haben den Nachteil, daß man mit wachsender Anzahl von Filterkoeffizienten sehr schnell an die Grenzen der Speicherkapazität heute zur Verfügung stehender ROMs gerät.

Auch Gleichung (2) läßt sich auf zwei unterschiedliche Weisen auswerten. Der erste Weg führt zur sogenannten direkten Form von Filterstrukturen - sie entsprechen der direkten Auswertung von Gleichung (1) - und der zweite Weg, der formal mit der Auswertung des Polynoms H(z) nach dem Hornerschen Schema übereinstimmt, führt zur sogenannten transponierten direkten Form von Filterstrukturen. Im Gegensatz zur direkten Form eignet sich die transponierte direkte Form aus zwei Gründen für Filter mit sehr hoher Verarbeitungsgeschwindigkeit. Bei ihr dienen nämlich die erforderlichen getakteten Verzögerungsglieder gleichzeitig der vorübergehenden Speicherung von Zwischenergebnissen. Durch dieses sogenannte pipelining werden die Laufzeitunterschiede der parallel zueinander verarbeiteten Bits des Eingangssignals ausgeglichen. Die Parallelverarbeitung ist der zweite Grund der Eignung für hohe Verarbeitungsgeschwindigkeiten. Das Filter funktioniert dann fehlerfrei, wenn die Laufzeiten oder die Laufzeitunterschiede zwischen zwei Verzögerungsgliedern kleiner als eine Periodendauer des Bittaktes bleiben.

Um ein Filter der transponierten direkten Form handelt es sich bei dem von Ulbrich et al. beschriebenen Filter. Die Autoren schlagen in dem erwähnten Artikel auch vor, die Filterkoeffizienten im CSD-Code (Canonical Signed Digit Code) darzustellen. Durch diesen Code werden Zahlen - wie beim Dualcode - als Linearkombinationen von Zweierpotenzen dargestellt, jedoch dürfen die Koeffizienten der Zweierpotenzen -

im Gegensatz zum Dualcode - die Werte 0, 1, oder -1 annehmen. Der CSD-Code ist umkehrbar eindeutig wegen der zusätzlichen Forderung, daß zwei aufeinander folgenden Zweierpotenzen nicht beide von Null verschiedene Koeffizienten haben dürfen. Der CSD-Code zeichnet sich dadurch aus, daß er zur Darstellung einer Zahl die geringste Anzahl von Einsen enthält.

Der Erfindung liegt die Aufgabe zugrunde, eine auf der Auswertung von Gleichung (1) basierendes Filter mit den eingangs genannten Merkmalen anzugeben, das gegenüber den bisher bekannten, auf Gleichung (1) beruhenden Filtern eine neue Struktur aufweist, sich für sehr hohe Verarbeitungsgeschwindigkeiten (Abtastfrequenzen bis zu 20 MHz) eignet und auch bei großer Zahl von Filterkoeffizienten (mindestens 25) mit den zur Zeit zur Verfügung stehenden Mitteln realisierbar ist.

Diese Aufgabe wird dadurch gelöst, daß die Codeworte des Eingangssignals durch ein Schieberegister mit K-Stufen zu je W-Binärstellen geschoben werden,
daß jedem Zahlenpaar p,w mit p = 0, 1, 2... P-1 und w = 0, 1, 2... W-1 zwei Wallace-Trees zugeordnet sind,
daß die w-te Binärstelle der k-ten Stufe des Schieberegisters für k = 0, 1, 2... K-1 dann mit einem Eingang des ersten Wallace-Trees verbunden ist, wenn die p-te Binärstelle des k-ten Koeffizienten mit einer + 1 besetzt ist oder mit einem Eingang des zweiten Wallace-Trees verbunden ist, wenn die p-te Binärstelle des k-ten Koeffizienten mit einer -1 besetzt ist,
daß auf alle ersten P Wallace-Trees mit festem w und für alle p eine erste Kaskade weiterer Wallace-Trees folgt, die der schrittweisen Umwandlung jener Zahl in eine Dualzahl dient, die durch die Ausgangsvariablen der ersten P Wallace-Trees als Linearkombination von P Zweierpotenzen dargestellt wird, daß der letzte Schritt dieser Umwandlung durch einen ersten Addierer für zwei Dualzahlen vorgenommen wird,
daß entsprechendes für alle zweiten Wallace-Trees, eine zweite Kaskade und einen zweiten Addierer für zwei Dualzahlen gilt,
daß auf die W ersten Addierer eine dritte Kaskade von Wallace-Trees folgt, die der schrittweisen Umwandlung jener Zahl in eine Dualzahl dient, die durch die Ausgangsvariablen der W ersten Addierer als Linearkombination von W Zweierpotenzen dargestellt wird, daß der letze Schritt dieser Umwandlung durch einen dritten Addierer für zwei Dualzahlen vorgenommen wird,
daß entsprechendes für die W zweiten Addierer, eine vierte Kaskade und einen vierten Addierer gilt und daß die Ausgänge des dritten und des vierten Addierers mit den Eingängen eines Subtrahierers für zwei Dualzahlen verbunden sind, an dessen Ausgang die Ausgangsvariablen des Filters anliegen.

Vorteilhafte Ausgestaltungen der Erfindung sind in den Unteransprüchen angegeben. Anhand der Figuren soll ein Ausführungsbeispiel der Erfindung näher erläutert werden.

Fig. 1 zeigt Einzelheiten eines Ausführungsbeispieles der Erfindung,
Fig. 2 zeigt das Prinzipschaltbild eines Ausführungsbeispiel der Erfindung und
Fig. 3 zeigt in einer Tabelle Filterkoeffizienten im CSD-Code und im Dezimal-Code.

Das als Ausführungsbeispiel gewählte nicht rekursive Filter hat 16 Koeffizienten (K = 16), deren 4-stellige (P = 4) Darstellung im CSD-Code der Tabelle in Fig. 3 zu entnehmen ist.

Die Abtastwerte des Eingangsignales bestehen aus 8-stelligen (W = 8) Codeworten im Dualcode.

Setzt man sowohl die Darstellung der Filterkoeffizienten

$$h(k) = \sum_{p=0}^{3} h_p(k) 2^{-p} \qquad (3)$$

im CSD-Code als auch die Darstellung der Abtastwerte

$$x(n-k) = \sum_{w=0}^{7} x_w(n-k) 2^{-w} \qquad (4)$$

im Dualcode in Gleichung (1) ein, so ergibt sich die Dreifachsumme

$$y(n) = \sum_{w=0}^{7}\left[\sum_{p=0}^{3}\left[\sum_{k=0}^{15} h_p(k)x_w(n-k)\right]2^{-p}\right]2^{-w}, \qquad (5)$$

bei der die Klammerung schon die Reihenfolge der Auswertung erkennen läßt. Zunächst soll die Auswertung der beiden innersten Klammern näher betrachtet werden, und zwar für w = 0, d.h. für das Bit mit der Wertigkeit $2^0$ aller 16 aufeinanderfolgender Abtastwerte. Die meisten Glieder der Summe über k sind Null wegen $h_p(k) = 0$. Die restlichen Glieder lassen sich zusammenfassen in solche, für die $h_p(k) = 1$ und solche für $h_p(k) = -1$. Bezeichnet man die Teilsummen über die positiven $h_p(k)$ mit $S^+_{o,p}$ und die über die negativen $-S^-_{o,p}$, so erkennt man folgendes: Der Beitrag zu $S^+_{o,p}$, der vom k-ten Filterkoeffizienten herrührt, ist $x_O$(n-k), falls an der p-ten Stelle des Koeffizienten h(k), eine 1 steht; der größte Wert, den $S^+_{o,p}$ annehmen kann, liegt dann vor, wenn bei jedem Filterkoeffizienten an der p-ten Stelle eine 1 steht und alle $x_O$(n-k) für k = 0, 1, 2,... 15 den Wert 1 annehmen. Tatsächlich steht nicht bei jedem Koeffizienten an der p-ten Stelle eine 1 - wie die Tabelle zeigt - sondern die Maximalzahl der Einsen ist - wie die vorletzte Zeile der Tabelle zeigt - für alle Stellen kleiner oder gleich 4. Daher kann auch $S^+_{o,p}$ nicht größer als 4 werden. Um z.B., $S^+_{o,o}$ zu berechnen, werden - wie Fig. 1 zeigt - die Binärwerte $x_O$(n-k) - sie sind in den Speicherstellen S00, S10... S150 gespeichert - für diejenigen k an die Eingänge eines ersten Wallace-Trees E00 geleitet, für die der 0-te Koeffizient an der p-ten Stelle eine 1 stehen hat (die 0-te Stelle ist die Stelle mit der Wertigkeit $2^O$). Ebenso wird für p = 1, 2 und 3 und den zugehörigen ersten Wallace-Trees E01, E02 und E03 verfahren.

Wallace-Trees sind Bausteine (S. z.B. der Baustein SN 74 LS 275 von Texas Instruments), die die Anzahl der an ihren Eingängen anliegenden Einsen als Dualzahl an ihren Ausgängen anzeigen.

Die Summe von (5) über p ist eine Linearkombination von Zweierpotenzen, deren Koeffizienten alle ganzzahligen Werte von 0 bis 4 annehmen können. Der Umwandlung dieser Zahlendarstellung in eine Darstellung als Dualzahl dienen die weiteren in Fig. 1 gezeigten und in Kaskade zu den ersten Wallace-Trees E0 geschalteten Wallace-Trees EK0 bzw. EK00, EK01, EK02 und EK03. Den Abschluß der Kaskade EK0 bildet ein schneller erster Addierer EA0 (carry look ahead adder) mit paralleler Übertragungslogik.

Genau wie eben beschrieben ist für die Fälle zu verfahren, für die $h_p(k) = -1$. Die hierfür erforderlichen Bausteine sind z.B. für w = 0 die in Fig. 2 als Block gezeigten zweiten Wallace-Trees Z0, eine zweite Kaskade ZK0 und ein zweiter Addierer ZA0 mit paralleler Übertragungslogik.

Was für w = 0 gesagt wurde, gilt entsprechend auch für die anderen Werte von w. Die Bausteine hierfür sind die zu ersten Wallace-Trees EW gehörigen, ebenfalls in Fig. 2 als Block gezeigten Wallace-Trees E1 bis E7, die zu ersten Kaskaden EK gehörigen Kaskaden EK1 bis EK7, die zu ersten Addierer gehörigen Addierer EA1 bis EA7, die zu zweiten Wallace-Trees ZW gehörigen Wallace-Trees Z1 bis Z7, die zu zweiten Kaskaden ZK gehörigen Kaskaden ZK1 bis ZK7 unddie zu zweiten Addierer ZA gehörigen Addierer ZA1 bis ZA7. Bezeichnet man in (5) die Summe über p für festes w und für die Fälle, für die $h_p(k) = 1$ ist, mit $SU^+_w(n)$ und für die Fälle, für die $h_p(k) = -1$ ist, mit $-SU^-_w(n)$, so wird aus (5):

$$y(n) = \sum_{w=0}^{7} SU^+_w(n)2^{-w} - \sum_{w=0}^{7} SU^-_w(n)2^{-w} \qquad (6)$$

Wiederum geht es - wie an den beiden Termen von (6) zu erkennen ist - um die Umwandlung einer Linearkombination von Zweierpotenzen mit beliebigen ganzzahligen positiven Koeffizienten in eine Dualzahl. Die Umwandlung erfolgt für beide Teilsummen von (6) getrennt, und zwar - wie Fig. 2 zeigt - durch eine dritte bzw. vierte Kaskade von Wallace-Trees DK, VK, die durch einen dritten bzw. vierten Addierer DA, VA mit paralleler Übertragungslogik abgeschlossen wird. Schließlich wird die Differenz A der Werte beider Teilsummen mit einem schneller Subtrahierer SU gewonnen; die Differenz A ergibt die Ausgangsvariable y-(n) als Dualzahl.

Um die Verarbeitungsgeschwindigkeit noch weiter zu erhöhen, sind zwischen den einzelnen Stufen - angedeutet durch unterbrochene Linien ZS - getaktete Zwischenspeicher eingesetzt. Die Taktversorgung für die Zwischenspeicher und für alle anderen Bausteine ist dem Fachmann geläufig, daher ist auf sie hier nicht weiter eingegangen.

Wie aus dem bisher erläuterten unmittelbar einsichtig, wird die Zahl der Multiplikationen und damit die Zahl der erforderlichen Bausteine geringer, je geringer die Zahl der Einsen in der CSD-Code-Darstellung der Filterkoeffizienten ist. Darum ist es von Vorteil, die Freiheit, die man bei der Wahl der Filterkoeffizienten - wegen des Toleranzschemas der Übertragungscharakteristik - hat, so zu nutzen, daß alle Koeffizienten möglichst viele Nullen enthalten.

## Patentansprüche

1. Digitales Filter, bei dem die W-stelligen Codeworte eines Eingangssignals bitparallel verarbeitet und die K Koeffizienten des Filters als P-stellige Codeworte des CSD-Codes verwendet werden,
**dadurch gekennzeichnet**,
daß die Codeworte des Eingangssignals (E) durch ein Schieberegister (SR) mit K Stufen (S0, S1....S15) zu je W Binärstellen geschoben werden,
daß jedem Zahlenpaar p,w mit p = 0, 1, 2... P-1 und w = 0, 1, 2... W-1 zwei Wallace-Trees zugeordnet sind,
daß die w-te Binärstelle der k-ten Stufe des Schieberegisters (SR) für k = 0, 1, 2... K-1 dann mit einem Eingang des ersten Wallace-Trees verbunden ist, wenn die p-te Binärstelle des k-ten Koeffizienten mit einer + 1 besetzt ist oder mit einem Eingang des zweiten Wallace-Trees verbunden ist, wenn die p-te Binärstelle des k-ten Koeffizienten mit einer -1 besetzt ist,
daß auf alle ersten P Wallace-Trees (E0, E1,....E7) mit festem w und für alle p eine erste Kaskade (EK0, EK1,....EK7) weiterer Wallace-Trees folgt, die der schrittweisen Umwandlung jener Zahl in eine Dualzahl dient, die durch die Ausgangsvariablen der ersten P Wallace-Trees als Linearkombination von P Zweierpotenzen dargestellt wird, daß der letzte Schritt dieser Umwandlung durch einen ersten Addierer (EA0, EA1,....EA7) für zwei Dualzahlen vorgenommen wird,
daß entsprechendes für alle zweiten Wallace-Trees (Z0, Z1....Z7), eine zweite Kaskade (ZK0, ZK1,....ZK7) und einen zweiten Addierer (ZA0, ZA1,....ZA7) für zwei Dualzahlen gilt,
daß auf die W ersten Addierer (EA0, EA1,....EA7) eine dritte Kaskade (DK) von Wallace-Trees folgt, die der schrittweisen Umwandlung jener Zahl in eine Dualzahl dient, die durch die Ausgangsvariablen der W ersten Addierer (EA0, EA1,....EA7) als Linearkombination von W Zweierpotenzen dargestellt wird, daß der letze Schritt dieser Umwandlung durch einen dritten Addierer (DA) für zwei Dualzahlen vorgenommen wird,
daß entsprechendes für die W zweiten Addierer (ZA0, ZA1,...ZA7), eine vierte Kaskade (VK) und einen vierten Addierer (VA) gilt und
daß die Ausgänge des dritten (DA) und des vierten (VA) Addierers mit den Eingängen eines Subtrahierer (SU) für zwei Dualzahlen verbunden sind, an dessen Ausgang die Ausgangsvariablen (A) des Filters anliegen.

2. Filter nach Anspruch 1, dadurch gekennzeichnet, daß es sich bei den Addierern und dem Subtrahierer (SU) um Bausteine mit paralleler Übertragungslogik handelt.

3. Filter nach Anspruch 1 oder 2, dadurch gekennzeichnet, daß zwischen den Kaskaden oder zwischen den einzelnen Stufen der Kaskaden getaktete Zwischenspeicher (ZS) eingefügt sind.

4. Filter nach Anspruch 1, 2, oder 3, dadurch gekennzeichnet, daß Freiheiten bei der Wahl der Filterkoeffizienten zur Einhaltung des Toleranzschemas der Filtercharakteristik so genutzt werden, daß jeder Filterkoeffizient möglichst viele Nullen im CSD-Code enthält.

## Claims

1. Digital filter having K coefficients, in which W-bit code words of an input signal are processed bit-parallel and the K filter coefficients are utilized as P-digit words in the CSD (Canonical Signed Digit) code, characterized
in that the code words of the input signal (E) are shifted through a shift register (SR) having K-stages (S0, S1, ..., S15) which are each W digits wide;

in that two Wallace Trees are assigned to each number pair p,w, where p = 0, 1, 2,..., P-1 and w = 0, 1, 2,...., W-1;

in that bit position w of stage k of the shift register (SR) for k = 0, 1, 2,... K-1 is connected to an input of the first Wallace Tree if digit position p of coefficient k is occupied by + 1, or is connected to an input of the second Wallace Tree if digit position p of the coefficient k is occupied by -1;

in that subsequent to all P first Wallace Trees (E0, E1, ..., E7) having a fixed w and for each p there is a first cascade (EK0, EK1, ..., EK7) of further Wallace Trees used for performing a step-by-step conversion of each number, represented as a linear combination of P powers of two by the output variables of the P first Wallace Trees, into a binary number;

in that the last step of this conversion is performed by a first adder (EA0, EA1, ..., EA7) for adding together two binary numbers;

in that the same holds for all the second Wallace Trees (Z0, Z1, ..., Z7), a second cascade of further Wallace Trees (ZK0, ZK1, ..., ZK7) and a second adder (ZA0, ZA1, ..., ZA7) for adding together two binary numbers;

in that subsequent to the W first adders (EA0, EA1, ..., EA7) there is a third cascade of Wallace Trees (DK) used for performing a step-by-step conversion of each number, represented as a linear combination of W powers of two by the output variables of the W first adders (EA0, EA1, ..., EA7), into a binary number;

in that the last step of this conversion is performed by a third adder (DA) for adding together two binary numbers;

in that the same holds for the W second adders (ZA0, ZA1, ..., ZA7), a fourth cascade of Wallace Trees (VK) and a fourth adder (VA);

and in that the outputs of the third and fourth adders (DA, VA respectively) are connected to the inputs of a subtracter (SU) for subtracting two binary numbers, at the output of which the output variables (A) of the filter are available.

2. Filter as claimed in Claim 1, characterized in that said adders and said subtracter (SU) are constituted by components having parallel transfer logic.

3. Filter as claimed in Claim 1 or 2, characterized in that clocked intermediate stores (ZS) are inserted between the cascades or between the individual stages of the cascades.

4. Filter as claimed in Claim 1, 2 or 3, characterized in that, adhering to a prescribed tolerance scheme of the filter characteristic, the freedom of selecting the filter coefficients has been utilized such that each filter coefficient contains as many zeroes in the CSD code as possible.

**Revendications**

1. Filtre numérique, dans lequel les mots de code à W positions d'un signal d'entrée sont traités en parallèle par bit et les K coefficients du filtre sont utilisés comme des mots de code à P positions du code CSD, caractérisé en ce que

les mots de code du signal d'entrée (E) sont décalés par un registre à décalage (SR) à K étages (S0, S1, ..., S15) vers chaque fois W positions binaires,

qu'à chaque paire de nombres p,w, où p=0, 1, 2, ..., P-1 et w=0, 1, 2, ..., W-1, sont associés deux arbres de Wallace,

que la w-ième position binaire du k-ième étage du registre à décalage (SR) pour k=0, 1, 2, ..., K-1 est connectée à une première entrée du premier arbre de Wallace, lorsque la p-ième position binaire du k-ième coefficient est occupée par un +1, ou à une entrée du deuxième arbre de Wallace, lorsque la p-ième position binaire du k-ième coefficient est occupée par un -1,

que les P premiers arbres de Wallace (E0, E1, ..., E7), avec w fixe et pour tous les p, sont tous suivis d'une première cascade (EK0, EK1, ..., EK7) d'autres arbres de Wallace servant à convertir pas à pas en un nombre binaire, le nombre qui est représenté par les variables de sortie des P premiers arbres de Wallace sous forme d'une combinaison linéaire de P puissances de deux, que le dernier pas de cette conversion est effectué par un premier additionneur (EA0, EA1, ..., EA7) pour deux nombres binaires,

que, d'une manière correspondante, il y a pour tous les deuxièmes arbres de Wallace (Z0, Z1, ..., Z7), une deuxième cascade (ZK0, ZK1, ..., ZK7) et un deuxième additionneur (ZA0, ZA1, ..., ZA7) pour deux nombres binaires;

que les W premiers additionneurs (EA0, EA1, ..., EA7) sont suivis d'une troisième cascade (DK) d'arbres de Wallace servant à la conversion pas à pas en un nombre binaire, du nombre qui est représenté par les variables de sortie des W premiers additionneurs (EA0, EA1, ..., EA7) sous la forme d'une combinaison linéaire de W puissances de deux, que le dernier pas de cette conversion est effectué par un troisième additionneur (DA) pour deux nombres binaires,

que, d'une manière correspondante, pour les W deuxièmes additionneurs (ZA0, ZA1, ..., ZA7), il y a une quatrième cascade (VK) et un quatrième additionneur (VA), et

que les sorties du troisième (DA) et du quatrième (VA) additionneur sont connectées aux entrées d'un soustracteur (SU) pour deux nombres binaires, à la sortie duquel sont appliquées les variables de sortie (A) du filtre.

**2.** Filtre suivant la revendication 1, caractérisé en ce que, dans le cas des additionneurs et du soustracteur (SU), il s'agit de modules à logique de transfert parallèle.

**3.** Filtre suivant la revendication 1 ou 2, caractérisé en ce qu'entre les cascades ou entre les étages individuels des cascades sont insérées des mémoires intermédiaires cadencées (ZS).

**4.** Filtre suivant la revendication 1, 2 ou 3, caractérisé en ce que des tolérances existant dans la sélection des coefficients de filtre en vue de respecter le schéma des tolérances de la caractéristique du filtre sont mises à profit pour que chaque coefficient de filtre contienne le plus de zéros possible dans le code CSD.

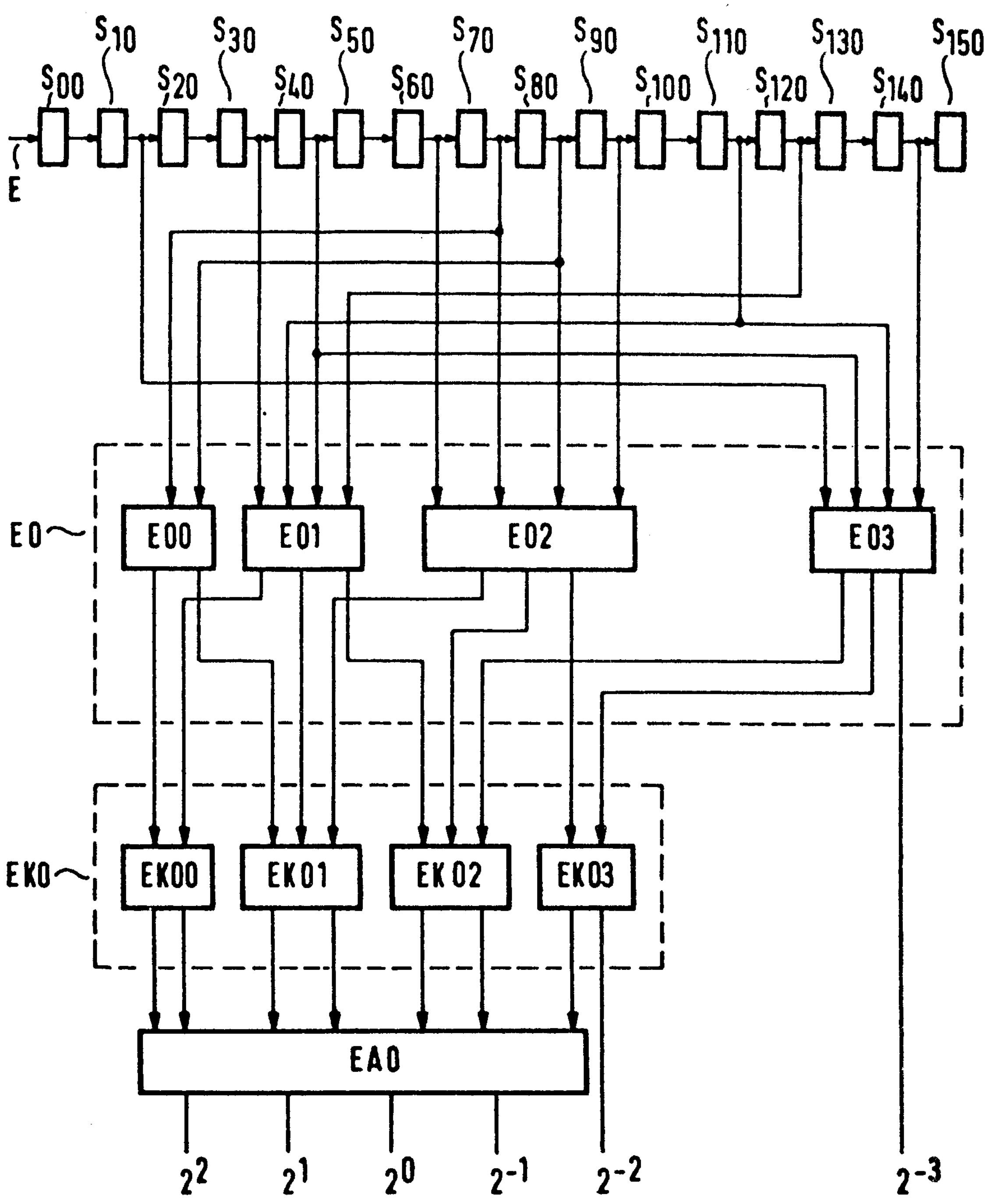
S00
S10
S20
S30
S40
S50
S60
S70
S80
S90
S100
S110
S120
S130
S140
S150
E
E0
E00
E01
E02
E03
EK0
EK00
EK01
EK02
EK03
EA0
2^2
2^1
2^0
2^-1
2^-2
2^-3

FIG. 1

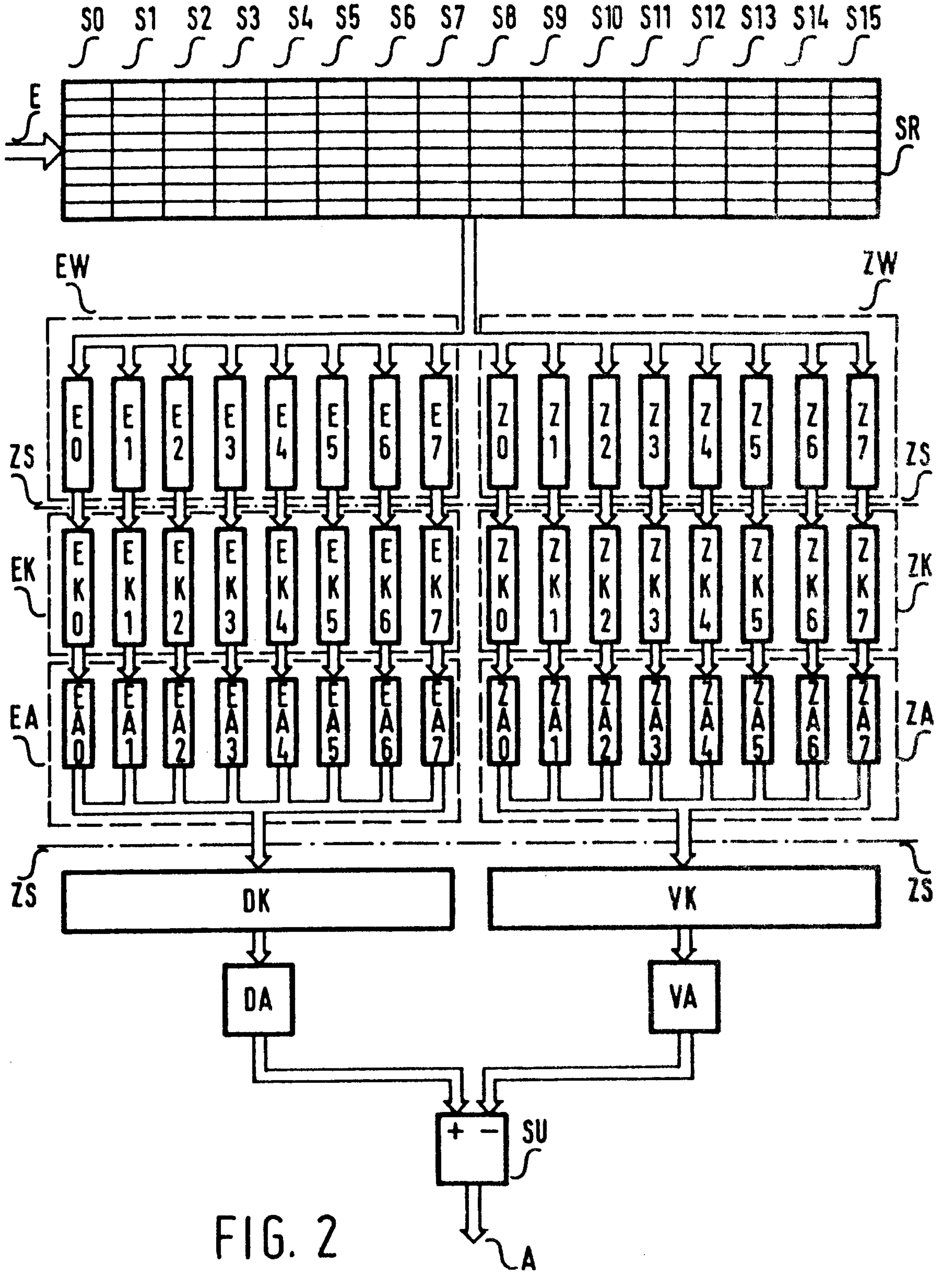
S0
S1
S2
S3
S4
S5
S6
S7
S8
S9
S10
S11
S12
S13
S14
S15
E
SR
EW
ZW
E0 E1 E2 E3 E4 E5 E6 E7
Z0 Z1 Z2 Z3 Z4 Z5 Z6 Z7
ZS
EK
EK0 EK1 EK2 EK3 EK4 EK5 EK6 EK7
ZK
ZK0 ZK1 ZK2 ZK3 ZK4 ZK5 ZK6 ZK7
EA
EA0 EA1 EA2 EA3 EA4 EA5 EA6 EA7
ZA
ZA0 ZA1 ZA2 ZA3 ZA4 ZA5 ZA6 ZA7
DK
VK
DA
VA
+ −
SU
A

FIG. 2

| p / h (k) | CSD-Code 0 1 2 3 | Decimal |
|---|---|---|
| h (0) | 0 0 0 -1 | -0,125 |
| h (1) | 0 0 0 1 | 0,125 |
| h (2) | 0 0 -1 0 | -0,250 |
| h (3) | 0 1 0 -1 | 0,375 |
| h (4) | 0 1 0 1 | 0,625 |
| h (5) | 0 -1 0 0 | -0,500 |
| h (6) | 0 0 1 0 | 0,250 |
| h (7) | 1 0 1 0 | 1,125 |
| h (8) | 1 0 1 0 | 1,125 |
| h (9) | 0 0 1 0 | 0,250 |
| h(10) | 0 -1 0 0 | -0,500 |
| h(11) | 0 1 0 1 | 0,625 |
| h(12) | 0 1 0 -1 | 0,375 |
| h(13) | 0 0 -1 0 | -0,250 |
| h(14) | 0 0 0 1 | 0,125 |
| h(15) | 0 0 0 -1 | -0,125 |
| max $S^{+}_{w,p}$ | 2 4 4 4 | |
| max $S^{-}_{w,p}$ | 0 2 2 4 | |

FIG. 3